# FASCICULE DE BREVET EUROPEEN

(11) **EP 1 302 954 B1**
(45) Date de publication et mention de la délivrance du brevet: **30.07.2008**
(21) Numéro de dépôt: 02354157.6
(22) Date de dépôt: 09.10.2002
(51) Int. Cl.: H01F 41/04, H01F 17/00, H01L 23/64, H01L 21/02

(54) **Réalisation d'inductance et de via dans un circuit monolithique**
Herstellungsverfahren eines Induktors und eines Kontaktlochs in einer integrierten Schaltung
Process for manufacturing an inductance and a via hole in an integrated circuit

(30) Priorité: 10.10.2001 FR 0113055; 27.11.2001 FR 0115307; 14.06.2002 FR 0207383
(43) Date de publication de la demande: 16.04.2003
(73) Titulaire: STMicroelectronics S.A., 92120 Montrouge (FR)
(72) Inventeur: Gardes, Pascal, 37100 Tours (FR)
(74) Mandataire: de Beaumont, Michel

(56) Documents cités:
- EP-A- 0 551 735
- EP-A- 0 685 857
- PATENT ABSTRACTS OF JAPAN vol. 014, no. 244 (E-0932), 24 mai 1990 (1990-05-24) & JP 02 067752 A (NEC CORP), 7 mars 1990 (1990-03-07)

## Description

La présente invention concerne un procédé de fabrication dans un circuit monolithique d'un via traversant et d'une inductance. Plus précisément, elle concerne une inductance du type décrit dans la demande de brevet français non publiée n°01/13055 (B5230) déposée par la demanderesse le 10 octobre 2001.

La demanderesse a décrit dans la demande de brevet français non publiée n°01/15307 (B5231) déposée le 27 novembre 2001 un circuit monolithique double face associant des composants actifs et passifs. Des vias traversant permettent d'établir des connexions entre la face avant et la face arrière.

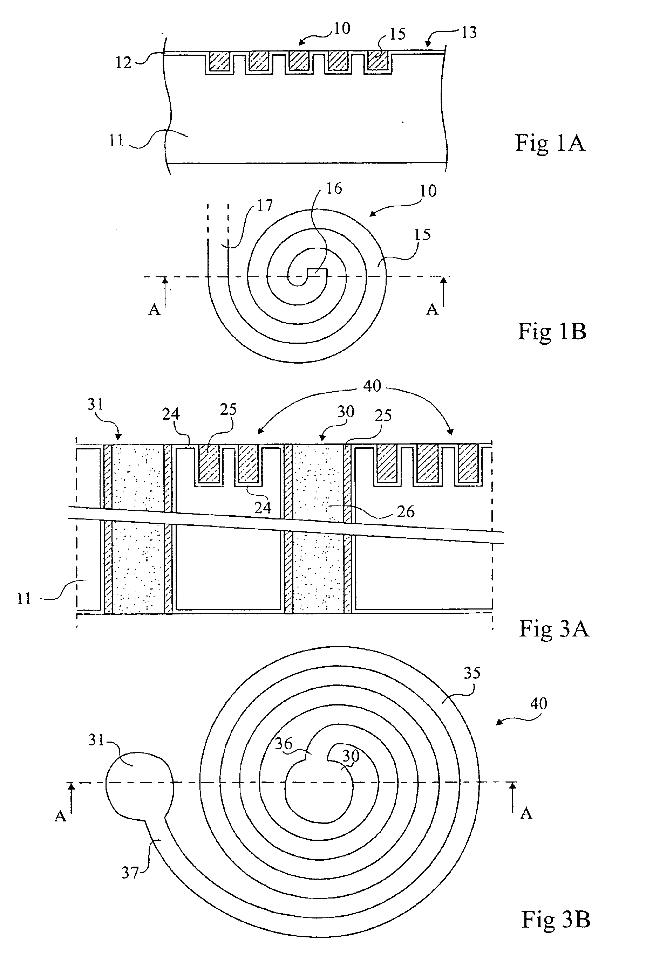

Les figures 1A et 1B représentent une vue en coupe et une vue de dessus de l'inductance de la demande de brevet français n°01/13055. L'inductance 10 est formée à partir d'une tranchée gravée dans un substrat 11. La tranchée est classiquement obtenue par gravure anisotrope (par exemple, une gravure plasma) qui expose une partie du substrat 11 selon un motif du type de celui de la figure 1B. La tranchée est isolée du substrat 11 par une couche conforme isolante 12, par exemple une couche d'oxyde de silicium. La tranchée est ensuite remplie d'un matériau conducteur 15 réalisant l'inductance 10. L'inductance a la forme d'une spirale (circulaire ou non) présentant des première 16 et deuxième 17 extrémités, la première extrémité 16 étant située sensiblement au centre de la spirale.

Lorsque l'on souhaite réaliser une inductance du type ci-dessus dans un circuit monolithique comportant un ou plusieurs vias 20 traversant le substrat de silicium 11 pour reporter des contacts d'une face à l'autre, le nombre d'étapes de fabrication doit être augmenté. En effet, les différences de dimension entre les gravures nécessaires à la réalisation de l'inductance 10 et des vias 20 entraînent que ces gravures ne peuvent être effectuées en même temps. De plus, avec les procédés de gravure usuels utilisant un masque de gravure, il est nécessaire de terminer l'une des deux structures (inductance ou via) avant de pouvoir graver l'autre structure. Il faut en effet reboucher les trous ou tranchées réalisés pour pouvoir redéposer un masque de gravure de définition de l'autre structure.

Le fait de devoir réaliser séparément les deux structures entraîne qu'une seule d'entre elle peut bénéficier des avantages d'avoir son matériau conducteur isolé du substrat par un oxyde thermique formé à haute température (de l'ordre de 1000°C). En effet, si l'on procédait à une deuxième étape de recuit alors que l'une des structures est terminée, les températures élevées impliquées détérioreraient cette première structure.

La présente invention vise la réalisation d'au moins une inductance et d'au moins un via traversant dans un circuit monolithique avec des étapes de formation communes.

L'invention vise en particulier à rendre commune l'étape de réalisation d'une couche isolante sur les parois respectives de la tranchée de l'inductance et des trous traversant des vias.

La présente invention vise également à permettre la réalisation de cette couche isolante de revêtement des tranchées et des vias par un même oxyde thermique.

L'invention vise également à proposer un procédé de réalisation d'inductance et de via dans un circuit monolithique qui minimise le nombre d'étapes de fabrication.

Pour atteindre ces objets et d'autres, la présente invention prévoit un procédé de fabrication, dans un circuit monolithique comprenant un substrat, d'une inductance et d'un via traversant, dans lequel on forme, depuis une première face du substrat, au moins une tranchée selon le contour de l'inductance à former ; comportant en outre les étapes consistant à former par laser dans le substrat un trou traversant à l'emplacement souhaité pour le via ; isoler simultanément la surface de la tranchée et du trou ; et déposer un matériau conducteur dans la tranchée et au moins sur les parois du trou, le matériau conducteur dans la tranchée réalisant l'inductance.

Selon un mode de réalisation de la présente invention, l'isolement est réalisé par oxydation thermique.

Selon un mode de réalisation de la présente invention, la tranchée est formée par gravure plasma.

Selon un mode de réalisation de la présente invention, l'étape de dépôt d'un matériau conducteur dans la tranchée et sur les parois des trous est suivie d'une étape de comblement du trou par un matériau isolant.

Selon un mode de réalisation de la présente invention, le procédé comprend en outre une étape de planarisation des deux faces du substrat.

Selon un mode de réalisation de la présente invention, un via est prévu à l'aplomb d'une extrémité centrale de la tranchée de l'inductance.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A décrite précédemment est une vue en coupe d'une inductance ;
la figure 1B décrite précédemment est une vue de dessus de l'inductance de la figure 1A ;
les figures 2A, 2B, 2C, 2D et 2E illustrent, par des vues en coupe, des étapes successives d'un mode de mise en oeuvre du procédé de réalisation d'inductance et de via selon la présente invention ; et
les figures 3A et 3B sont des vues, respectivement en coupe et de dessus, illustrant un mode de réalisation d'une inductance intégrée et de vias dans un circuit monolithique selon la présente invention.

Les mêmes éléments et couches ont été désignés par les mêmes références aux différentes figures. Pour des raisons de clarté, seules les étapes de procédé et les constituants qui sont nécessaires à la compréhension de l'invention ont été illustrés et seront décrits par la suite. De plus, dans les différentes figures, comme cela est usuel dans le domaine de la représentation de circuits monolithiques, les épaisseurs et dimensions latérales des diverses couches ne sont pas tracées à l'échelle ni à l'intérieur d'une même figure ni d'une figure à l'autre pour améliorer la lisibilité des figures.

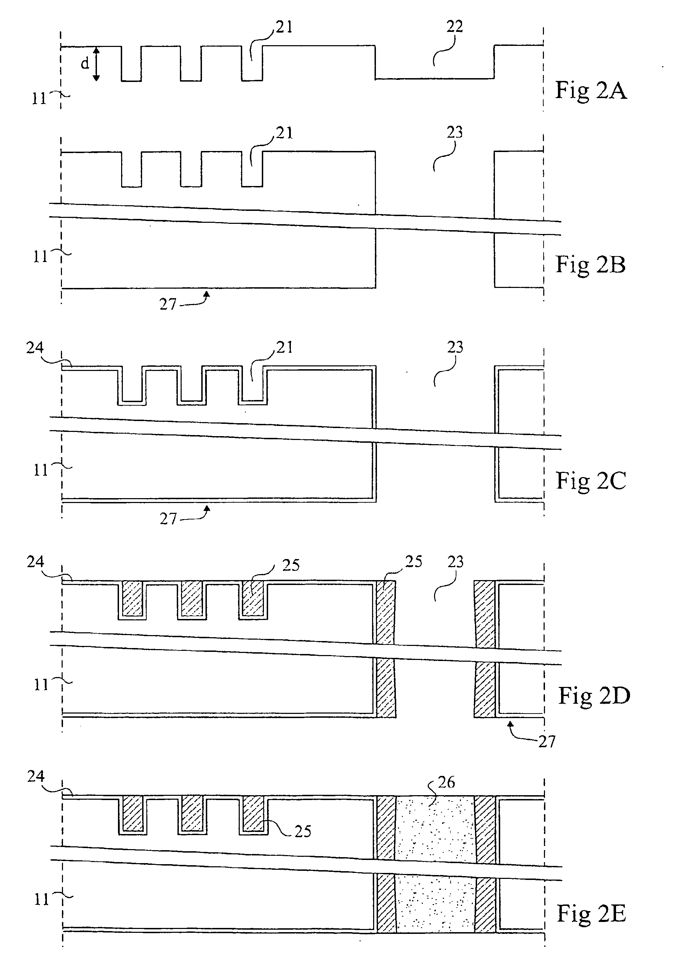

La figure 2A représente un substrat semiconducteur 11, par exemple en silicium, dans lequel on a formé une tranchée 21 selon le tracé d'une inductance à réaliser et, optionnellement, une cavité 22 à l'endroit d'un via à réaliser. La profondeur d de la tranchée 21 (et de la cavité 22 éventuelle) est fonction de l'épaisseur de l'inductance souhaitée. La tranchée 21 et la cavité 22 sont obtenues par une gravure anisotrope, par exemple par plasma, du substrat 11 recouvert d'un masque qui expose les régions 21 et 22.

La figure 2B illustre la structure obtenue à l'issue d'une deuxième étape caractéristique de l'invention qui consiste à percer un ou plusieurs trous 23 traversant le substrat au moyen d'un laser, aux endroits souhaités pour le ou les vias.

La réalisation de la tranchée 21 de l'inductance par gravure plasma permet de tirer profit de la précision d'une telle gravure. Par contre, pour la réalisation des trous traversants, on tire profit du perçage laser qui ne nécessite pas de masque photolithographique pour être réalisé.

La tranchée aura par exemple une profondeur de 7 à 15 µm et une largeur de 1 à 2 µm. Le perçage laser fournit un trou traversant d'un diamètre de l'ordre d'une vingtaine de µm, ou plus.

Selon une caractéristique essentielle de la présente invention, les étapes des figures 2A et 2B sont effectuées successivement et le perçage laser est effectué sans que la tranchée 21 soit préalablement recouverte d'une couche de protection.

Si une cavité 22 est réalisée par gravure plasma à l'endroit du trou à percer, elle pourra aider au positionnement du laser.

La figure 2C illustre une troisième étape du procédé de l'invention dans laquelle on forme simultanément, au niveau de la tranchée 21 et du trou traversant 23, une couche conforme isolante 24, par exemple une couche d'oxyde de silicium.

Selon un mode de mise en oeuvre préféré de la présente invention, la couche 24 est obtenue par oxydation thermique. On notera ici un avantage essentiel de l'invention qui est de permettre l'obtention d'un même isolant, et de préférence d'un même oxyde thermique sur les parois des structures de via et d'inductance, et donc d'obtenir les mêmes qualités électriques. Cela est rendu possible selon l'invention grâce au fait que tous les évidements (tranchée 21 et trous 23) sont réalisés, sans qu'il soit nécessaire de prévoir une étape intermédiaire de protection d'une des deux structures.

La figure 2D illustre la structure obtenue après une quatrième étape du procédé de l'invention qui consiste à remplir la tranchée 21 d'un matériau conducteur 25. Le matériau 25 est également déposé sur les flancs du via 23. Le matériau 25 est de préférence un métal, par exemple du cuivre, de l'or, du nickel, de l'aluminium ou du titane.

Le dépôt du métal 25 est de préférence réalisé par électrolyse. Dans ce cas, on commence par pulvériser un métal sur les parois à revêtir. On obtient un remplissage complet de la tranchée 21 et le dépôt d'une couche conductrice sur les flancs du trou 23.

Selon une variante de réalisation, le matériau métallique 25 est entièrement déposé par pulvérisation. Dans ce cas, on veillera à ce que l'épaisseur de matériau obtenu à l'intérieur du via dans la région centrale du substrat 11 soit suffisante pour la conduction.

Ensuite, comme l'illustre la figure 2E, le vide restant dans le trou traversant 23 est rempli, de préférence d'un matériau isolant 26 (par exemple, du verre ou de la résine).

Après dépôt du matériau métallique 25 et du matériau isolant 26, on met en oeuvre une étape de planarisation de la surface du substrat au niveau de l'inductance et éventuellement sur la face opposée 27. La planarisation peut être réalisée par un procédé de polissage mécano-chimique (CMP).

On obtient alors une inductance intégrée au substrat 11 et isolée de celui-ci par la couche 24 ainsi qu'un via conducteur permettant un report de contact entre les deux faces du substrat 11. L'ensemble présente des surfaces sensiblement planes permettant la réalisation ultérieure d'autres composants passifs ou actifs, et/ou de niveaux de métallisation d'interconnexion et/ou de réseaux de bossages conducteurs pour un boîtier de type "flip-chip" d'un côté ou de l'autre.

Les figures 3A et 3B illustrent, respectivement par une vue en coupe et par une vue de dessus, un mode de réalisation préféré de la présente invention dans lequel un via 30, percé par laser conformément au procédé décrit précédemment, est positionné approximativement au centre de la spirale 35 d'une inductance 40 pour connecter l'extrémité centrale 36 de celle-ci par la face opposée du substrat 11 aux autres composants ou plots auxquels elle doit être reliée.

Dans cet exemple, on a également représenté un via 31 reliant l'extrémité externe 37 de la spirale 35 en face opposée du substrat 11. Les connexions de l'inductance sont alors toutes effectuées en face arrière, à l'opposé de la face portant l'inductance 40.

Selon un autre exemple non représenté où les connexions sont effectuées depuis la face avant, le contact de l'extrémité centrale 36 de la spirale est ramené sur la face avant à l'extérieur de la structure au moyen du via 30 central de la spirale 35 et d'un via externe, les deux vias étant connectés en face arrière par une piste conductrice.

Un avantage du mode de réalisation des figures 3A et 3B est qu'il supprime les éventuelles capacités parasites liées à la réalisation de connexions vers l'extrémité centrale de la spirale inductive du côté de la face avant du substrat 11.

Bien entendu, la présente invention est susceptible de diverses variantes et modifications qui apparaîtront à l'homme de l'art. En particulier, la mise en oeuvre pratique du procédé de l'invention est à la porté de l'homme du métier à partir des indications fonctionnelles données ci-dessus que ce soit pour déterminer les dimensions (largeur, longueur, épaisseur) de la ou des spirales inductives ou pour déterminer les conditions opératoires à appliquer.

De plus, bien que seule une inductance et un via aient été représentés, plusieurs inductances et plusieurs vias pourraient être réalisés. De plus les étapes de fabrication d'inductances et de vias selon l'invention peuvent s'insérer dans un procédé plus général de réalisation d'un circuit monolithique incluant d'autres éléments passifs et/ou actifs.

## Revendications

1. Procédé de fabrication, dans un circuit monolithique comprenant un substrat (11), d'une inductance (40) et d'un via traversant (30, 31), dans lequel on forme, depuis une première face du substrat, au moins une tranchée (21) selon le contour de l'inductance à former ;
**caractérisé en ce qu'**il comporte en outre les étapes successives suivantes :
former par laser dans le substrat un trou traversant (23) à l'emplacement souhaité pour le via ;
isoler simultanément (24) la surface de la tranchée et du trou ; et
déposer un matériau conducteur (25) dans la tranchée et au moins sur les parois du trou, le matériau conducteur (25) dans la tranchée réalisant l'inductance (40).

2. Procédé selon la revendication 1, dans lequel l'isolement est réalisé par oxydation thermique.

3. Procédé selon la revendication 1, dans lequel la tranchée (21) est formée par gravure plasma.

4. Procédé selon la revendication 1, dans lequel l'étape de dépôt d'un matériau conducteur (25) dans la tranchée (21) et sur les parois des trous (23) est suivi d'une étape de comblement du trou par un matériau isolant (26).

5. Procédé selon l'une quelconque des revendications 1 à 4, comprenant en outre une étape de planarisation des deux faces du substrat (11).

6. Procédé selon la revendication 1, dans lequel un via (30) est prévu à l'aplomb d'une extrémité centrale (36) de la tranchée (35) de l'inductance (40).

## Claims

1. A method for manufacturing, in a monolithic circuit comprising a substrate (11), an inductance (40) and a through via (30, 31), in which is formed, from a first surface of the substrate, at least one trench (21) according to the contour of the inductance to be formed;
**characterized in that** it further includes the successive steps of:
forming by laser in the substrate a through hole (23) at the location desired for the via;
simultaneously insulating (24) the surface of the trench and the hole; and
depositing a conductive material (25) in the trench and at least on the hole walls, the conductive material (25) in the trench constituting the inductance.

2. The method of claim 1, wherein the insulation is performed by thermal oxidation.

3. The method of claim 1, wherein the trench (21) is formed by plasma etching.

4. The method of claim 1, wherein the step of deposition of a conductive material (25) in the trench (21) and on the walls of the holes (23) is followed with a step of filling up the hole with an insulating material (26).

5. The method of any of claims 1 to 4, further comprising a step of planarization of both surfaces of the substrate (11).

6. The method of claim 1, wherein a via (30) is provided above a central end (36) of the trench (35) of the inductance (40).

## Patentansprüche

1. Verfahren zur Herstellung einer Induktanz (40) und eines Via bzw. einer Durchkontaktierung (30, 31) in einer monolithischen Schaltung, die ein Substrat (11) aufweist, bei dem wenigstens ein Graben (21) gemäß der Kontur der zu formenden Induktanz ausgebildet wird, und zwar von einer ersten Oberfläche des Substrats her;
**dadurch gekennzeichnet, dass** das Verfahren ferner die folgenden aufeinanderfolgende Schritte aufweist:
Ausbilden eines Durchgangslochs (23) in dem Substrat durch einen Laser, und zwar an dem Ort, der für das Via vorgesehen ist;
simultanes Isolieren (24) der Oberfläche des Grabens und des Lochs; und
Abscheiden eines leitenden Materials (25) in dem Graben und an wenigstens den Lochwänden, wobei das leitende Material (25) in dem Graben die Induktanz bildet.

2. Verfahren nach Anspruch 1, wobei die Isolierung durch thermische Oxidation durchgeführt wird.

3. Verfahren nach Anspruch 1, wobei der Graben (21) durch Plasmaätzen gebildet wird.

4. Verfahren nach Anspruch 1, wobei der Schritt der Abscheidung eines leitenden Materials (25) in dem Graben (21) und an den Wänden der Löcher (23) gefolgt wird durch einen Schritt des Auffüllens des Lochs mit einem isolierenden Material (26).

5. Verfahren nach einem der Ansprüche 1 bis 4, das ferner den Schritt der Planarisierung beider Oberflächen des Substrats (11) aufweist.

6. Verfahren nach Anspruch 1, wobei ein Via (30) an einem mittigen Ende (36) des Grabens (35) der Induktanz (40) vorgesehen ist.
